(19) Europäisches Patentamt
European Patent Office
Office européen des brevets

(11) **EP 3 030 917 B1**

(12) **EUROPÄISCHE PATENTSCHRIFT**

(45) Veröffentlichungstag und Bekanntmachung des Hinweises auf die Patenterteilung:
**14.06.2017 Patentblatt 2017/24**

(51) Int Cl.:
**G01R 33/30** *(2006.01)*     **G01R 33/345** *(2006.01)*
**G01R 33/28** *(2006.01)*     **G01R 33/62** *(2006.01)*

(21) Anmeldenummer: **14744514.2**

(22) Anmeldetag: **23.07.2014**

(86) Internationale Anmeldenummer:
**PCT/EP2014/065826**

(87) Internationale Veröffentlichungsnummer:
**WO 2015/018640 (12.02.2015 Gazette 2015/06)**

(54) **MIKROWELLENKOPPLER ZUR OPTIMIERUNG EINES NMR-PROBENKOPFES FÜR MAS-DNP**

MICROWAVE COUPLER FOR OPTIMIZING A NMR PROBE HEAD FOR MAS-DNP

DISPOSITIF DE COUPLAGE MICRO-ONDES POUR OPTIMISER UNE TÊTE D'ÉCHANTILLON RMN POUR PDN AVEC ROTATION À L'ANGLE MAGIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.08.2013 DE 102013215782**

(43) Veröffentlichungstag der Anmeldung:
**15.06.2016 Patentblatt 2016/24**

(73) Patentinhaber: **Bruker BioSpin GmbH**
**76287 Rheinstetten (DE)**

(72) Erfinder:
• **PUREA, Armin**
**76669 Bad Schönborn (DE)**
• **ENGELKE, Frank**
**76287 Rheinstetten (DE)**
• **KRAHN, Alexander**
**76137 Karlsruhe (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**DE-A1-102008 009 376     JP-A- H02 182 001**

• **THUMM M ET AL: "DESIGN OF SHORT HIGH-POWER TE11-HE11 MODE CONVERTERS IN HIGHLY OVERMODED CORRUGATED WAVEGUIDES", IEEE TRANSACTIONS ON MICROWAVE THEORY AND TECHNIQUES, IEEE SERVICE CENTER, PISCATAWAY, NJ, US, Bd. 39, Nr. 2, 1. Februar 1991 (1991-02-01), Seiten 301-309, XP000175519, ISSN: 0018-9480, DOI: 10.1109/22.102974**
• **BARNES A B ET AL: "Cryogenic sample exchange NMR probe for magic angle spinning dynamic nuclear polarization", JOURNAL OF MAGNETIC RESONANCE, ACADEMIC PRESS, ORLANDO, FL, US, Bd. 198, Nr. 2, 1. Juni 2009 (2009-06-01), Seiten 261-270, XP026101448, ISSN: 1090-7807, DOI: 10.1016/J.JMR.2009.03.003 [gefunden am 2009-03-17]**
• **THORSTEN MALY ET AL: "Simplified THz Instrumentation for High-Field DNP-NMR Spectroscopy", APPLIED MAGNETIC RESONANCE, SPRINGER VIENNA, VIENNA, Bd. 43, Nr. 1 - 2, 9. Juni 2012 (2012-06-09), Seiten 181-194, XP035084415, ISSN: 1613-7507, DOI: 10.1007/S00723-012-0360-7**

**Beschreibung**

Die Erfindung betrifft einen NMR(=Kernspinresonanz)-DNP(=Dynamic Nuclear Polarization)-MAS (=Magic-Angle-Spinning)-Probenkopf mit einem MAS-Stator zur Aufnahme eines MAS-Rotors mit einer Probensubstanz in einem Probenvolumen und einem hohlen Mikrowellenleiter zur Zuführung von Mikrowellenstrahlung durch eine Öffnung des Mikrowellenleiters in das Probenvolumen, mit einem längs einer Achse ausgedehnten und in der Öffnung des Mikrowellenleiters befindlichen stabförmigen Mikrowellenkoppler aus dielektrischem Material. "Stabförmig" bedeutet in diesem Zusammenhang, dass die Länge in Richtung der Stabachse länger ist als die Ausdehnung in den hierzu orthogonalen Richtungen.

Eine solche Anordnung ist bekannt aus DE 10 2008 009 376 A1 (=Referenz [0]).

Referenz [5] zeigt eine ähnliche Anordnung, allerdings ohne einen längs einer Achse ausgedehnten und in der Öffnung des Mikrowellenleiters befindlichen stabförmigen Mikrowellenkoppler aus dielektrischem Material.

**Hintergrund der Erfindung**

Magnetische Kernresonanz mit Magic Angle Spinning (=MAS-NMR)

In einer Magic Angle Spinning (MAS)-Vorrichtung zur Durchführung von Experimenten basierend auf magnetischer Kernresonanz (NMR) wird eine zu untersuchende Probe in einem zylinderförmigen MAS-Rotor innerhalb eines MAS-Stators platziert und pneumatisch unter Rotation versetzt. NMR-Anregung und Detektion erfolgen auf üblichem Weg mittels einer Solenoidspule, in deren Mitte zylindersymmetrisch der Rotor eingebracht wird.

Dynamische Kernpolarisation (=DNP)

Auf dem Feld der Kernmagnetischen Resonanz-Spektroskopie gibt es experimentelle Methoden, die es erlauben, die Kern-Polarisation und damit die Detektionsempfindlichkeit des Experimentes signifikant zu erhöhen. Eine dieser Methoden ist die dynamische Kernpolarisation (=DNP). Diese Technik erfordert die gleichzeitige Einstrahlung eines magnetischen Mikrowellenfeldes zur Polarisation von Elektronenspins, auf einer Frequenz die etwa um den Faktor 660 höher ist als die Larmorfrequenz der 1 H Kernspins.

Eine typische DNP-Anordnung besteht aus einer NMR Spule, die auf eine Kern-Larmorfrequenz abgestimmt wird (z.B. $^1$H - 400 MHz) und der gleichzeitigen Einstrahlung eines Mikrowellenfeldes auf 263 GHz.

DNP-Anordnungen sind beispielsweise in Referenz [7] beschrieben.

MAS-DNP-NMR

Bei Kombination von MAS-NMR mit dynamischer Kernpolarisation (DNP) zum Zwecke der Signalerhöhung muss zusätzlich eine Einstrahlung der Probe mit einer elektromagnetischen Welle im oberen Mikrowellenlsub-THz-Bereich erfolgen. Dieser Ansatz wird beschrieben in den Referenzen [2] bis [6].

Der Mikrowellen/sub-THz-Strahl wird durch einen Mikrowellenleiter zum Bereich der Probe geführt, und durch ein offenes Ende entweder senkrecht zur Achse des Rotors (radial) - siehe Referenzen [3] bis [5] - oder parallel hierzu (axial) - siehe Referenzen [2] und [6] - auf den Rotor und die Probe gestrahlt. Die räumliche Ausdehnung des Strahls senkrecht zur Propagationsrichtung ist üblicherweise größer ist als die Fläche des Rotors, wodurch nur ein Teil der Strahlungsenergie für den DNP-Effekt genutzt wird. Bei radialer Einstrahlung wurde daher mit einer Linse aus dielektrischem Material eine Veränderung der Strahlform erreicht, die besser an die Querschnittsfläche des Rotors angepasst wurde - siehe Referenzen [1] und [3].

Nachteile des Standes der Technik

Durch den Abstand der strahlenden Wellenleiter-Apertur zur Probe und der Divergenz des Mikrowellen/sub-THz-Strahls ist der Querschnitt des Strahls am Probenort in mindestens einer Dimension deutlich größer als der Querschnitt der Probe, so dass die Energiedichte am Probenort reduziert wird. Hinzu kommen Streueffekte des Strahls an dielektrischen Grenzschichten, die die Feldstärke weiter reduzieren können. Um dennoch die notwendige Feldstärke in der Probe zu erzeugen, muss eine aufwändige Hochleistungs-Mikrowellenquelle benutzt werden - siehe Referenzen [4] bis [6].

Bei dem Mikrowellenkoppler gemäß der eingangs zitierten Referenz [0] (=DE 10 2008 009 376 A1) soll eine Einkopplung von TE-Moden in den Resonator erfolgen. Dazu ist der Mikrowellenkoppler bündig mit den Wänden ausgeführt, was ja für diesen Einsatzzweck physikalisch erforderlich ist. Dies ist aber für eine Einkopplung der HE11-Mode weder erforderlich noch günstig.

Aufgabe der Erfindung

Der vorliegenden Erfindung liegt demgegenüber die Aufgabe zugrunde, einen NMR-DNP-MAS-Probenkopf der eingangs definierten Art zur Verfügung zu stellen, mit dem eine fokussierte und damit effizientere Mikrowellen-Einstrahlung in das Probenvolumen möglich ist und bei dem die Probe möglichst homogen polarisiert wird, wobei insbesondere die HE11-Mode optimal eingekoppelt werden soll.

Kurze Beschreibung der Erfindung

Diese Aufgabe wird auf überraschend einfache Art und Weise sowie mit ohne Weiteres zur Verfügung stehenden technischen Mitteln gelöst durch einen NMR-DNP-MAS-Probenkopf mit den eingangs genannten Merkmalen, der dadurch gekennzeichnet ist, dass der Mikrowellenleiter zur Einkopplung eines HE11-Mode einen probenseitigen Endabschnitt aufweist, der die Öffnung definiert, in welcher sich der Mikrowellekoppler mit einem allseitigen radialen Abstand befindet, sowie ein sich daran anschliessendes konisch zulaufendes hohles Übergangsstück, in welches der Mikrowellenkoppler hinein ragt.

Im Gegensatz zu dem bündig mit den Wänden ausgeführten Mikrowellenkoppler gemäß Referenz [0] ist bei der vorliegenden Erfindung wesentlich, dass der stabförmige Mikrowellenkoppler eben gerade nicht bündig mit den Wänden des Mikrowellenleiters verbunden ist, sondern durch einen umlaufenden radialen Spalt vom den Wänden der Öffnung des Mikrowellenleiters beabstandet ist. Dies sorgt letztlich dafür, dass die gewünschte HE11-Mode optimal eingekoppelt werden kann.

Durch den zulaufenden Konus des hohlzylindrischen Mikrowellenleiters lässt sich die sich ausbreitende Welle auf eine geringere Ausdehnung bündeln. Damit ist es möglich, eine erheblich effizientere Einkopplung des Mikrowellen Strahls in das Probenvolumen zu realisieren. Dabei dient der stabförmige Koppler zur Konzentration des Mikrowellenfeldes und zur Führung des Strahls bis direkt an das Probenvolumen.

In der Referenz [0] sind zwar auch konisch zulaufende Übergänge offenbart, jedoch geometrisch an anderer Stelle sowie zu einem anderen Zweck. Der Mikrowellenkoppler ragt in ähnlicher Konfiguration in den Resonator hinein. Im Mikrowellenleiter befindet sich das konische Übergangsstück jedoch außerhalb. Die Richtung spielt hier aber eine wichtige Rolle. Mit der Vorrichtung gemäß vorliegender Erfindung gelingt es nämlich, den HE11-Mode -also einen Gaußähnlichen Mode- optimal einzufangen, was physikalisch insbesondere mit der konischen Ausführung vor der Einkopplung in den Mikrowellenkoppler zusammenhängt. Dabei wird keine Mode seitlich eingekoppelt, wie in Referenz [0] gezeigt, sondern auf der Stirnfläche. In Referenz [0] ragt der Mikrowellenkoppler nicht in das konisch zulaufende hohle Übergangsstück hinein. Vielmehr durchtritt er dieses in ganzer Länge. In Referenz [0] ist im Unterschied zur vorliegenden Erfindung die Einkopplung von Moden in einen Resonator beschrieben. Dabei geht es nicht darum, einfach nur Mikrowellenleistung zu transportieren, sondern in dem betreffenden Volumen eine stehende Welle zu erzeugen, in die dann eine Probe gebracht wird. Im Unterschied dazu ist die Zielstellung der vorliegenden Erfindung, möglichst viel Leistung zu dem weiter entfernten MAS-Rotor zu bringen. Jedoch ist weder der Rotor noch seine unmittelbare Umgebung eine beabsichtigt resonante Struktur. Deshalb und auch wegen der Ausbreitungseigenschaften ist hierfür ein Gaußscher Strahl am besten geeignet, auf den auch das Gesamtdesign der erfindungsgemäßen Vorrichtung angepasst wurde, da die HE11-Mode im freien Raum in einen Gaußschen Strahl übergeht

<u>Weitere Vorteile gegenüber dem Stand der Technik</u>

Im Gegensatz zum Standard-Probenkopf kann durch die erfindungsgemäße Verwendung eines stabförmigen Mikrowellenkopplers der Querschnitt des Mikrowellen-Strahls auf die Probengeometrie angepasst und dadurch die Energiedichte des magnetischen Mikrowellen-Feldes signifikant erhöht werden.

Ein solches Design ist insbesondere nützlich um Proben, die klein im Vergleich zum Strahlquerschnitt sind, effizient zu polarisieren. Insbesondere für langgestreckte Proben, wie sie typischerweise in MAS-Systemen verwendet werden, wird durch den Koppler in Verbindung mit einer axialen Einstrahlung eine homogene Polarisation auf der kompletten Länge erreicht.

Mit Hilfe des erfindungsgemäßen Probenkopfes lassen sich kompakte Festkörper-Mikrowellenquellen verwenden, weil durch die höhere Energiedichte eine geringere Mikrowellenleistung notwendig ist, um eine gegebene Feldstärke am Probenort zu erzeugen.

<u>Bevorzugte Ausführungsformen der Erfindung</u>

Eine besonders bevorzugte Ausführungsform, sieht vor, dass die Abmessungen des Mikrowellenkopplers senkrecht zu seiner Stabachse mindestens der halben Wellenlänge der eingestrahlten Mikrowellenstrahlung im Mikrowellenkoppler entsprechen, außer in eventuell konischen und/oder trichterförmigen Segmenten am Anfang und Ende des Mikrowellenkopplers. Dadurch wird sichergestellt, dass die Welle im Koppler ausbreitungsfähig ist.

Bevorzugt ist weiterhin eine Ausführungsform, bei der der Mikrowellenkoppler für eine Mikrowellen-Frequenz im Bereich von 100 - 1000 GHz ausgelegt ist, wobei die minimale Ausdehnung im stabförmigen Bereich des Mikrowellenkopplers $0{,}15\,mm/\sqrt{\varepsilon_r}$ - $1{,}5\ mm/\sqrt{\varepsilon_r}$ beträgt und wobei $\varepsilon_r$ der relativen Dielektrizitätszahl des Materials entspricht, aus dem der Mikrowellenkoppler aufgebaut ist. Die Abmessungen werden damit auf relevante Werte eingegrenzt.

Besonders bevorzugt sind auch Ausführungsformen des erfindungsgemäßen Probenkopfes, bei denen der Mikrowellenkoppler mindestens ein trichterförmiges und/oder ein konusförmiges und/oder ein stufiges Ende aufweist. Dadurch wird die Einkopplung bzw. Auskopplung optimiert.

Bei einer weiteren vorteilhaften Ausführungsform des erfindungsgemäßen Probenkopfes weist der Mikrowellenkoppler ein Querschnittsprofil auf, welches in einem axialen Mittenbereich konstant ist. Der Mikrowellenleiter ist zylindersymmetrisch, diese Symmetrie wird daher im Mikrowellenkoppler aufgegriffen, um keine Symmetriebrechung zu verursachen.

Eine bevorzugte Weiterbildung dieser Ausführungsform sieht vor, dass das Querschnittsprofil des Mikrowellenkopplers auf seiner radial äußeren Oberfläche in einem axialen Mittenbereich konstant ist.

Ganz besonders vorteilhaft sind Ausführungsformen des erfindungsgemäßen NMR-Probenkopfs, bei welchen der Mikrowellenleiter hohl ist und innen eine periodische Riffelung aufweist. Dadurch wird eine verlustarme Transmission mit der HE11-Mode innerhalb des Kopplers ermöglicht.

Eine Klasse von Ausführungsformen des erfindungsgemäßen NMR-Probenkopfs zeichnen sich dadurch aus, dass die Achse des Mikrowellenkopplers quer, vorzugsweise senkrecht zur Rotationsachse des MAS-Rotors angeordnet ist. Durch die seitliche, vorzugsweise radiale Einstrahlrichtung ist der Weg der Welle durch Rotor und Probe so kurz wie möglich.

In einer dazu alternativen Klasse von Ausführungsformen ist die Achse des Mikrowellenkopplers im Wesentlichen parallel zur Rotationsachse des MAS-Rotors angeordnet. Durch die axiale Einstrahlrichtung kann die Welle durch den Rotor geführt werden.

Diese Ausführungsformen lassen sich durch Weiterbildungen verbessern, bei denen das dem Probenvolumen zugewandte axiale Ende des Mikrowellenkopplers als Bodenlager des MAS-Stators ausgebildet und fest mit diesem verbunden ist. Bei axialer Einstrahlung ist das Bodenlager räumlich zwischen Rotor/Probenvolumen und Mikrowellenleiter angeordnet. Ein Koppler muss dann gleichzeitig die Funktion des Bodenlagers übernehmen, damit die Performance der MAS-Vorrichtung nicht beeinträchtigt wird.

Eine weitere vorteilhafte Ausführungsform des erfindungsgemäßen Probenkopfes ist auf der dem Mikrowellenkoppler gegenüberliegenden Seite des MAS-Stators ein Spiegel zur Reflexion der aus dem Mikrowellenkoppler austretenden und durch das Probenvolumen hindurchtretenden Mikrowellenstrahlung vorhanden. Durch die Reflexion passiert die Mikrowellenstrahlung das Probenvolumen zweimal statt nur einmal, woraus eine Effizienzerhöhung im Transfer der Mikrowellenstrahlung in die Probe zum Zwecke der Elektronenpolarisation resultieren kann.

Besonders bevorzugt sind Ausführungsformen, bei welchen ein pneumatisches Probenwechselsystem zum Zuführen und Abführen eines MAS-Rotors zum MAS-Stator vorgesehen ist, wie es beispielsweise in DE 10 2006 048 955 B4 ausführlich beschrieben wird.

Vorteilhaft sind auch Ausführungsformen des erfindungsgemäßen Probenkopfes, die sich dadurch auszeichnen, dass der MAS-Stator zur Einstellung des MAS-Winkels drehbar gelagert ist, wie etwa in DE 10 2008 054 152 B3 beschrieben.

Bei einer ganz besonders bevorzugten Klasse von Ausführungsformen des erfindungsgemäßen Probenkopfes ist zwischen Mikrowellenkoppler und Mikrowellenleiter mindestens ein Abstandshalter aus dielektrischem Material vorgesehen, der eine Distanz von mindestens einem Viertel der Wellenlänge der einzukoppelnden Mikrowellenstrahlung überbrückt.

Bei vorteilhaften Weiterbildungen dieser Ausführungsformen ist mindestens ein Abstandshalter als Distanzring, vorzugsweise als eine Vielzahl von Distanzringen, ausgeführt.

Alternativ oder ergänzend kann bei Weiterbildungen auch mindestens ein Abstandshalter als auf den Mikrowellenleiter aufsteckbare Kappe ausgeführt sein, in die der Mikrowellenkoppler integriert ist.

Weitere vorteilhafte Ausführungsformen des erfindungsgemäßen Probenkopfes schließlich sind dadurch gekennzeichnet, dass der Mikrowellenkoppler aus nicht-magnetischen, dielektrischen Materialien mit geringem Verlustwinkel (tan $\delta$ < 10$^{-3}$) aufgebaut ist, insbesondere aus PTFE oder Saphir.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1 eine schematische Längsschnitt-Darstellung eines erfindungsgemäßen NMR-MAS-Probenkopfes mit in das hohle Ende eines Mikrowellenleiters ragendem Mikrowellenkoppler in axialer Anordnung;

Fig. 2 wie Fig. 1, aber mit radial zur Rotor-Achse angeordnetem Mikrowellenleiters und in diesen ragenden Mikrowellenkoppler;

Fig. 3 eine schematische Detail-Darstellung eines hohlen Mikrowellenleiters mit am einen Ende konisch erweiterter Bohrung und am anderen Ende hineinragendem zylindrischen Mikrowellenkoppler;

Fig. 4a wie Fig. 3, aber mit einem Mikrowellenkoppler mit beidseitig konvexen, konusförmigen Enden;

Fig. 4b wie Fig. 4a, wobei aber das aus dem Mikrowellenleiter herausragende konusförmige Ende des Mikrowellenkopplers konkav ist;

Fig. 5 eine elektromagnetische Feldsimulation mit der jeweils berechneten x-Komponente des E-Feld, wobei

a) eine Feldverteilung bei freier Propagation des Gaußschen Mikrowellenstrahl aus dem Mikrowellenleiter ohne Koppler und
b) eine entsprechende Feldverteilung bei Einsatz eines in den Mikrowellenleiter ragenden typischen Mikrowellenkopplers angenommen wurde;

Fig. 6      ein MAS-System nach dem Stand der Technik mit axialem, als Bernoulli Lager ausgeführtem Bodenlager;

Fig. 7      einen schematischen Längsschnitt des in das hohle Ende eines Mikrowellenleiters ragenden Mikrowellenkopplers mit Distanzringen als Befestigungsvariante; und

Fig. 8      einen schematischen Längsschnitt des in das hohle Ende eines Mikrowellenleiters ragenden Mikrowellenkopplers mit einer Befestigungsvariante, bei der der Koppler in eine aufsteckbare Abdeckkappe integriert ist.

Die vorliegende Erfindung betrifft eine neue Systematik zur Aufnahme von DNP MAS Spektren auf dem Gebiet der NMR und umfasst einen NMR-DNP-MAS-**Probenkopf 10; 20** mit einem **MAS-Stator 2** zur Aufnahme eines **MAS-Rotors** 3 mit einer Probensubstanz in einem **Probenvolumen 4** und einem **hohlen Mikrowellenleiter 5** zur Zuführung von Mikrowellenstrahlung durch eine **Öffnung 5a** des Mikrowellenleiters 5 in das Probenvolumen 4. Gegenüber bekannten Vorrichtungen zeichnet sich die Erfindung dadurch aus, dass in der Öffnung 5a des Mikrowellenleiters 5 ein längs einer Achse ausgedehnter, im Wesentlichen **stabförmiger Mikrowellenkoppler 6; 6'; 6"** aus dielektrischem Material angeordnet ist.

Auf der dem Mikrowellenkoppler 6; 6'; 6" gegenüberliegenden Seite des MAS-Stators 2 kann ein **Spiegel 7; 7'** zur Reflexion der aus dem Mikrowellenkoppler 6; 6'; 6" austretenden und durch das Probenvolumen 4 hindurchtretenden Mikrowellenstrahlung vorgesehen sein.

Die Hauptanwendung der vorliegenden Erfindung liegt auf dem Gebiet der Kern-Resonanz-Spektroskopie (NMR) sowie vorzugsweise auf dem Feld der dynamischen Kernpolarisation (DNP).

Zur Optimierung des Mikrowellen/sub-THz-Strahls soll erfindungsgemäß ein Mikrowellenkoppler 6; 6'; 6" eingesetzt werden. Dieser Koppler hat die Funktion, die Intensität eines auf die Messprobe einfallenden Mikrowellen-Strahls in der HE11-Mode einzufangen, zu leiten und in einer kontrollierten Form wieder abzugeben. Der Mikrowellenkoppler kann zylinderförmig, elliptisch oder konisch geformt sein. Er besteht typischerweise aus einem Dielektrikum mit vernachlässigbarer elektrischer Leitfähigkeit ($< 10^{-10}$ S/m).

Dieser Mikrowellenkoppler kann im Zusammenhang mit DNP MAS auf zwei verschiedene Arten eingesetzt werden, um die Intensität der Mikrowellen/sub-THz-Strahlung am Ort der Probe zu erhöhen:

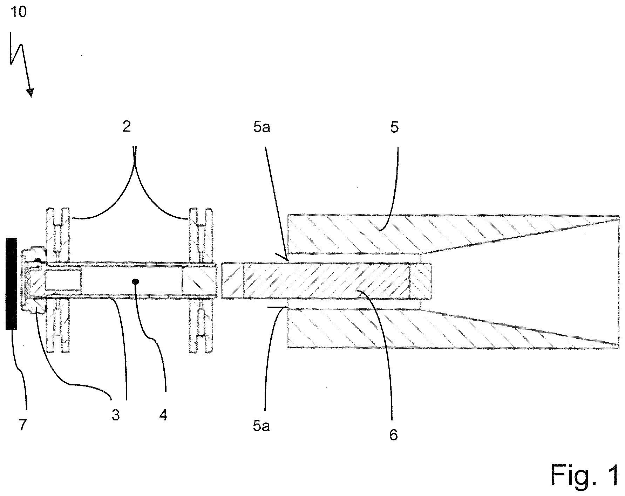

1. Bei axialer Einstrahlung kann das Bodenlager des MAS-Stators 2 so hergestellt werden, dass es gleichzeitig als Mikrowellenkoppler 6 im Sinne der vorliegenden Erfindung betrieben wird, und die einfallende Mikrowellen-/sub-THz-Strahlung in den innerhalb des MAS-Stators 2 angeordneten MAS-Rotor 3 leitet. Diese Konfiguration ist in **Figur 1** gezeigt, wobei der MAS-Stator 2 zeichnerisch nur durch seine beiden Luftlager-Scheiben dargestellt. Bei dieser Ausführungsform sind das Bodenlager und die Endkappe(n) des Rotors 3 gleichzeitig Teil des Kopplers 6.

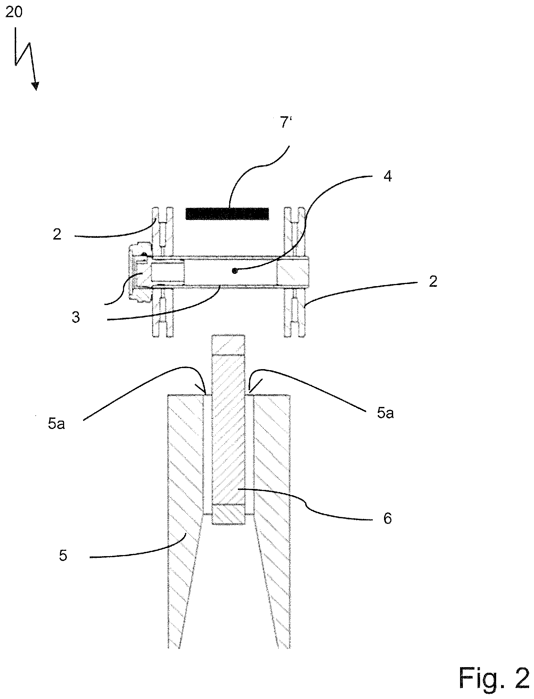

2. Bei radialer Einstrahlung kann die Öffnung in den MAS-Stator 2 deutlich kleiner als die Breite des einfallenden Mikrowellen-Strahls sein. Dann kann der Mikrowellenkoppler 6 den Strahl gebündelt in den Stator 2 führen und die Mikrowellen-Energie innerhalb des Stators 2 kontrolliert abgeben, wie in **Figur 2** gezeigt ist. Beide Enden des Mikrowellenkopplers 6 können daraufhin optimiert werden, dass möglichst wenig Strahlintensität reflektiert wird.

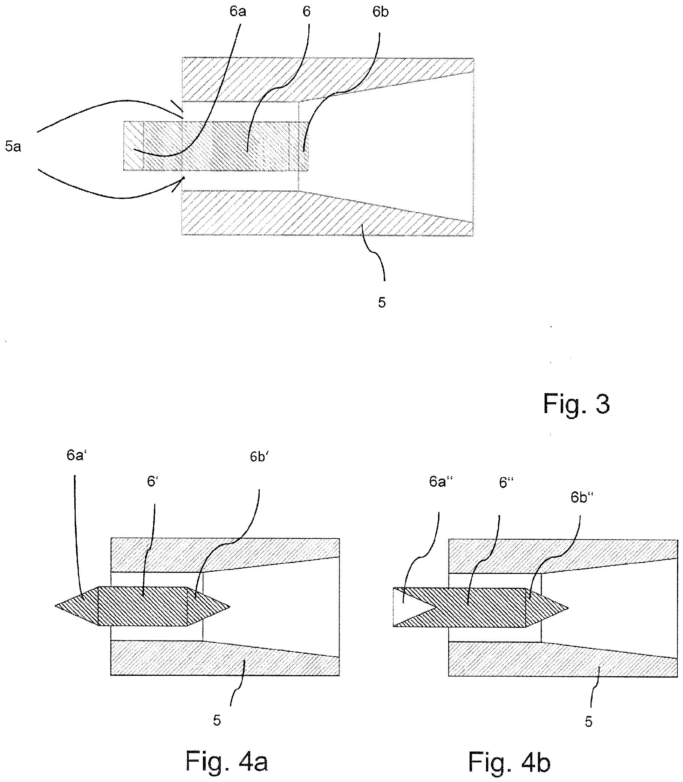

Die **Figur 3** stellt in größerem Detail den erfindungsgemäß eingesetzten hohlen Mikrowellenleiter 5 mit einer am einen Ende konisch erweiterten Bohrung dar. In die Öffnung 5a am anderen Ende des Mikrowellenleiters 5 ragt ein - bei dem hier gezeigten Ausführungsbeispiel zylindrisch geformter- Mikrowellenkoppler 6. Letzterer weist an dem aus der Öffnung 5a des Mikrowellenleiters 5 herausragenden Ende einen **ersten Endabschnitt 6a** auf, der als Kopplungsregion zum Fokussieren der abgestrahlten Mikrowellen-Energie auf die Messprobe dient. Der in den Mikrowellenleiter 5 hineinragende **zweite Endabschnitt 6b** hingegen markiert eine Moden-Konversions-Region.

Ein typischer für die vorliegende Erfindung eingesetzter Mikrowellenkoppler besteht aus einem ca. 5mm langen zylindrischen Dielektrikum mit einem Durchmesser von 2mm.

Die Enden des Mikrowellenkopplers können mindestens einen stufigen und/oder konusförmigen und/oder trichterförmigen **Endabschnitt 6a,6b; 6a',6b'; 6a",6b"** mit einer typischen Länge von jeweils 3mm aufweisen.

Die **Figur 4a** zeigt einen - in der Praxis meist bevorzugten - Mikrowellenkoppler 6' mit beidseitig konisch konvex geformten Endabschnitten 6a', 6b'.

In **Figur 4b** ist ein Mikrowellenkoppler 6" mit einem konisch konkav geformten ersten Endabschnitt 6a" und einem - wie bei der Ausführungsform gemäß Fig. 4a - konisch konvex geformten zweiten Endabschnitt 6b" gezeigt.

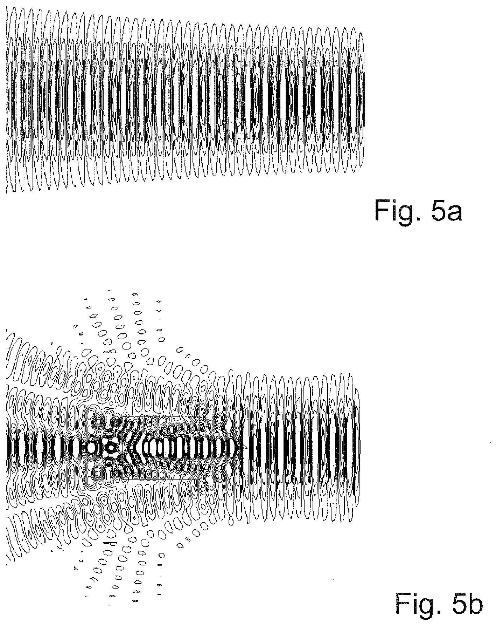

Um den Erfolg des erfindungsgemäßen Prinzips zu verdeutlichen, wurden zwei elektromagnetische Feldsimulationen durchgeführt und deren Ergebnisse in den **Figuren 5a und 5b** zeichnerisch dargestellt.

Im Einzelnen zeigt Fig. 5a eine Feldverteilung bei freier Propagation des Gaußschen Mikrowellenstrahl aus dem Mikrowellenleiter ohne Koppler.

Fig. 5b stellt eine entsprechende Feldverteilung zeichnerisch dar, bei welcher in der Simulationsrechnung der Einsatz eines in den Mikrowellenleiter ragenden Mikrowellenkopplers angenommen wurde. Wie man deutlich erkennt, erfolgt durch die erfindungsgemäße Verwendung eines Mikrowellenkopplers eine ganz erhebliche Konzentration der auf die Messprobe weitergeleiteten Mikrowellen-Energie.

Die in den Figuren 5a und vor allem 5b gezeigte Funktion eines erfindungsgemäß Mikrowellenkopplers mit typischen Abmessungen ist mit Hilfe einer Elektromagnetik-Feldsimulationssoftware (CST Microwave Studio 2012) ermittelt worden. Dabei propagiert ein Gaußscher Strahl (lineare Polarisation, E-Feld in x-Richtung) von der rechten Seite ausgehend in linker Richtung (z-Richtung). Dargestellt ist jeweils die x-Komponente des E-Feldes. Die Frequenz des Strahls liegt bei 263 GHz, also im sub-THz Bereich. Der Koppler besteht aus PTFE. Erkennbar ist die erhöhte Feldamplitude im Bereich hinter dem Koppler, in einem räumlich schmaleren Band.

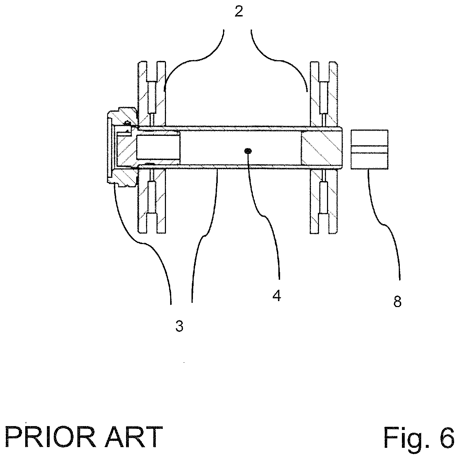

Die **Figur 6** schließlich zeigt schematisch zum deutlicheren Vergleich mit der vorliegenden Erfindung eine einfache NMR-DNP-MAS-Probenkopf-Anordnung nach dem Stand der Technik mit einem MAS-Stator 2 zur Aufnahme eines MAS-Rotors 3 mit einer Probensubstanz in einem Probenvolumen 4. Am rechten Ende der Figur 6 ist ein als **Bernoulli Lager 8** ausgeführtes Bodenlager dargestellt. An dieser Stelle befindet sich beim erfindungsgemäßen Probenkopf 10; 20 das Rotor-seitige Ende 6a; 6a'; 6a" des Mikrowellenkopplers 6; 6'; 6".

Der Mikrowellenkoppler 6; 6'; 6" weist einen radialen Mindestabstand zum Mikrowellenleiter 5 auf. Die HE11-Mode aus dem Mikrowellenleiter 5, an welche angekoppelt wird, besitzt ein zum Rand hin abklingendes Feldprofil (sowohl E-als auch H-Feld), so dass der wesentliche Teil der Mikrowellenintensität durch den Mikrowellenkoppler 6; 6'; 6" übertragen wird. Gleichzeitig selektiert der Mikrowellenkoppler 6; 6'; 6" eine solche Mode aus.

Der radiale Mindestabstand des Mikrowellenkopplers 6; 6'; 6"zum Mikrowellenleiter 5 beträgt eine Viertel Wellenlänge oder mehr, was durch -verglichen mit der Wellenlänge- dünne Abstandshalter aus dielektrischem Material von weniger als einem Viertel der Wellenlänge ermöglicht wird.

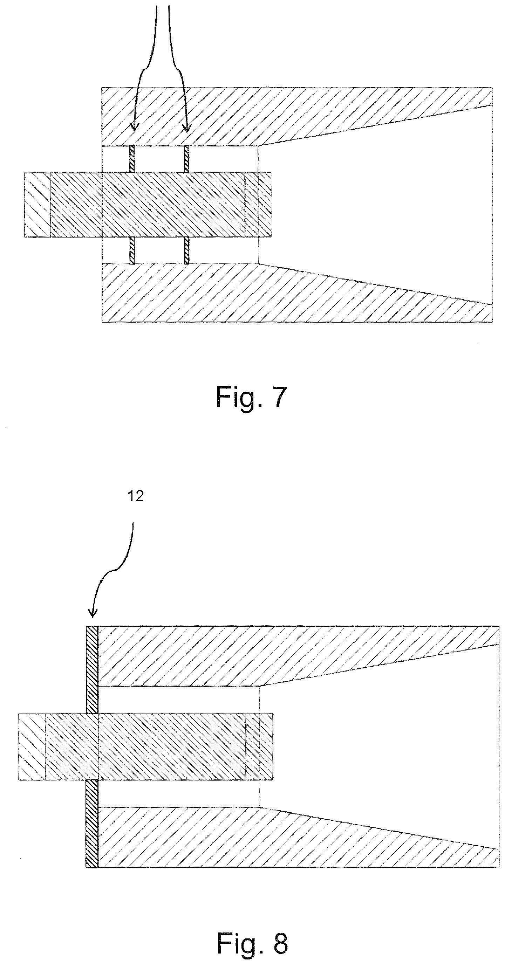

Dabei sind Ausführungsformen der möglich, die -wie in **Fig. 7** dargestellt- im Vergleich zur Wellenlänge dünne **Distanzringe 11** aufweisen.

Möglich sind auch Ausführungsformen mit auf den Mikrowellenleiter 5 **aufsteckbarer Kappe 12,** in die der Mikrowellenkoppler 6; 6'; 6" integriert ist - wie in **Fig. 8** dargestellt.

Besonders geeignet für den Mikrowellenkoppler 6; 6'; 6" sind nicht-magnetische, dielektrische Materialien mit geringem Verlustwinkel (tan $\delta$ < 10⁻³), beispielsweise PTFE oder Saphir.

## Abkürzungen

| ESR | electron spin resonance (Elektronen-Spin-Resonanz) |
| (N)MR | (nuclear) magnetic resonance (Kern-Spin-Resonanz) |
| DNP | dynamic nuclear polarization (Dynamische Kernpolarisation) |
| MAS | magic angle spinning |
| PBS | photonic band-gap structure |
| hrNMR | high resolution NMR (Hochauflösungs-NMR) |
| RF | in der NMR Spektroskopie elektromagnetischer Frequenzbereich von 1 MHz bis 1000 MHz |
| THz | Tera-Hertz, elektromagnetischer Frequenzbereich von 0.3 - 3 THz. |

## Referenzliste

[0] DE 10 2008 009 376 A1

[1] Barnes, Alexander et al.:

"Optimization of THz wave coupling into samples in DNP/NMR spectroscopy." Proceedings of the 2010 IEEE International Conference on Millimeter and Terahertz Waves: 1-3.

[2] Matsuki et al.:

"Dynamic nuclear polarization experiments at 14.1 T for solid-state NMR", PCCP 2010 (22), 5799-5803

[3] Nanni et al.:

"Microwave Field Distribution in a Magic Angle Spinning Dynamic Nuclear Polarization NMR Probe", J Magn Reson. 2011 May;210(1):16-23

[4] Bajaj V et al.:

"Dynamic nuclear polarization at 9 T using a novel 250 GHz gyrotron microwave source", J Magn Reson 2003 160(2): 85-90

[5] M. Rosay et al.:

"Solid-state dynamic nuclear polarization at 263 GHz: spectrometer design and experimental results", PCCP 2010 (22), 5850-5860

[6] Becerra et al.:

"A Spectrometer for Dynamic Nuclear Polarization and Electron Paramagnetic Resonance at High Frequencies", J Magn Reson. A 1995, 117 (1): 28-40

[7] V.Denysenkov, Th.Prisner:

"Liquid state Dynamic Nuclear Polarization probe with Fabry Perot resonator at 9.2 T", J. Magn. Reson. 217 (2012), 1-5

**Patentansprüche**

1. NMR(=Kernspinresonanz)-DNP(=Dynamic Nuclear Polarization)-MAS (=Magic-Angle-Spinning)-Probenkopf (10; 20) mit einem MAS-Stator (2) zur Aufnahme eines MAS-Rotors (3) mit einer Probensubstanz in einem Probenvolumen (4) und einem hohlen Mikrowellenleiter (5) zur Zuführung von Mikrowellenstrahlung durch eine Öffnung (5a) des Mikrowellenleiters (5) in das Probenvolumen (4), mit einem längs einer Achse ausgedehnten und in der Öffnung (5a) des Mikrowellenleiters (5) befindlichen stabförmigen Mikrowellenkoppler (6; 6'; 6") aus dielektrischem Material, **dadurch gekennzeichnet, dass** der Mikrowellenleiter (5) zur Einkopplung eines HE11-Mode einen probenseitigen Endabschnitt aufweist, der die Öffnung (5a) definiert, in welcher sich der Mikrowellenkoppler (6; 6'; 6") mit einem allseitigen radialen Abstand befindet, sowie ein sich daran anschließendes konisch zulaufendes hohles Übergangsstück , in welches der Mikrowellenkoppler (6; 6'; 6") hinein ragt.

2. Probenkopf nach Anspruch 1, **dadurch gekennzeichnet, dass** durch die Öffnung (5a) des Mikrowellenleiters (5) Mikrowellenstrahlung einer bestimmten Wellenlänge in das Probenvolumen (4) eingestrahlt wird, und dass die Abmessungen des Mikrowellenkopplers (6; 6'; 6") senkrecht zu seiner Stabachse mindestens der halben Wellenlänge der eingestrahlten Mikrowellenstrahlung im Mikrowellenkoppler (6; 6'; 6") entsprechen, außer in eventuell konischen und/oder trichterförmigen und/oder stufigen Segmenten am Anfang und Ende des Mikrowellenkopplers (6'; 6").

3. Probenkopf nach einem der vorhergehenden Ansprüche, **dadurch gekennzeichnet, dass** der Mikrowellenkoppler (6; 6'; 6") für eine Mikrowellen-Frequenz im Bereich von 100 - 1000 GHz ausgelegt ist, wobei die minimale Ausdehnung im stabförmigen Bereich des Mikrowellenkopplers (6; 6'; 6") $0,15 \text{mm}/\sqrt{\varepsilon_r}$ - $1,5 \text{ mm}/\sqrt{\varepsilon_r}$ beträgt und wobei $\varepsilon_r$ der relativen Dielektrizitätszahl des Materials entspricht, aus dem der Mikrowellenkoppler (6; 6'; 6") aufgebaut ist.

4. Probenkopf nach einem der vorhergehenden Ansprüche, **dadurch gekennzeichnet, dass** der Mikrowellenkoppler (6'; 6") mindestens einen stufigen und/oder konusförmigen und/oder trichterförmigen Endabschnitt (6a,6b; 6a',6b'; 6a",6b") aufweist.

5. Probenkopf nach einem der vorhergehenden Ansprüche, **dadurch gekennzeichnet, dass** der Mikrowellenkoppler (6; 6'; 6") ein Querschnittsprofil aufweist, welches in einem axialen Mittenbereich konstant ist, insbesondere auf seiner radial äußeren Oberfläche in einem axialen Mittenbereich.

6. Probenkopf nach einem der vorhergehenden Ansprüche, **dadurch gekennzeichnet, dass** der Mikrowellenleiter (5) hohl ist und innen eine periodische Riffelung aufweist.

7. Probenkopf nach einem der Ansprüche 1 bis 6, **dadurch gekennzeichnet, dass** die Achse des Mikrowellenkopplers (6; 6'; 6") quer, vorzugsweise senkrecht zur Rotationsachse des MAS-Rotors (3) angeordnet ist.

8. Probenkopf nach einem der Ansprüche 1 bis 6, **dadurch gekennzeichnet, dass** die Achse des Mikrowellenkopplers (6; 6'; 6") im Wesentlichen parallel zur Rotationsachse des MAS-Rotors (3) angeordnet ist.

9. Probenkopf nach Anspruch 8, **dadurch gekennzeichnet, dass** das dem Probenvolumen zugewandte axiale Ende des Mikrowellenkopplers (6; 6'; 6") als Bodenlager des MAS-Stators (2) ausgebildet und fest mit diesem verbunden ist.

10. Probenkopf nach einem der vorhergehenden Ansprüche, **dadurch gekennzeichnet, dass** auf der dem Mikrowellenkoppler (6; 6'; 6") gegenüberliegenden Seite des MAS-Stators (2) ein Spiegel (7; 7') zur Reflexion der aus dem Mikrowellenkoppler (6; 6'; 6") austretenden und durch das Probenvolumen (4) hindurchtretenden Mikrowellenstrahlung vorhanden ist.

11. Probenkopf nach einem der vorhergehenden Ansprüche, **dadurch gekennzeichnet, dass** zwischen Mikrowellenkoppler (6; 6'; 6") und Mikrowellenleiter (5) mindestens ein Abstandshalter aus dielektrischem Material vorgesehen ist, der eine Distanz von mindestens einem Viertel der Wellenlänge der einzukoppelnden Mikrowellenstrahlung überbrückt.

**12.** Probenkopf nach Anspruch 11, **dadurch gekennzeichnet, dass** mindestens ein Abstandshalter als Distanzring (11), vorzugsweise als eine Vielzahl von Distanzringen (11), ausgeführt ist.

**13.** Probenkopf nach Anspruch 11 oder 12, **dadurch gekennzeichnet, dass** mindestens ein Abstandshalter als auf den Mikrowellenleiter (5) aufsteckbare Kappe (12), ausgeführt ist, in die der Mikrowellenkoppler (6; 6'; 6") integriert ist.

**14.** Probenkopf nach einem der vorhergehenden Ansprüche, **dadurch gekennzeichnet, dass** der Mikrowellenkoppler (6; 6'; 6") aus nicht-magnetischen, dielektrischen Materialien mit geringem Verlustwinkel (tan $\delta$ <10$^{-3}$) aufgebaut ist, insbesondere aus PTFE oder Saphir.

**Claims**

**1.** NMR (=nuclear magnetic resonance) DNP (=dynamic nuclear polarization)-MAS (=magic angle spinning) probe head (10; 20) comprising an MAS stator (2) for receiving an MAS rotor (3) having a sample substance in a sample volume (4), and a hollow microwave waveguide (5) for feeding microwave radiation through an opening (5a) of the microwave waveguide (5) into the sample volume (4), with an axially extended rod-shaped microwave coupler (6; 6'; 6") made of dielectric material disposed in the opening (5a) of the microwave waveguide (5), **characterized in that** the microwave waveguide (5) has an end section on the sample side for coupling in an HE 11 mode which defines the opening (5a) in which the microwave coupler (6; 6'; 6") is located at an all-round radial distance and an adjacent conically tapered hollow transition piece, into which the microwave coupler (6; 6'; 6") projects.

**2.** Probe head according to claim 1, **characterized in that** microwave radiation of a certain wavelength is irradiated through the opening (5a) of the microwave guide (5) into the sample volume (4) and that the dimensions of the microwave coupler (6; 6'; 6") perpendicular to its rod axis are at least half the wavelength of the irradiated microwave radiation in the microwave coupler (6; 6'; 6"), except in possibly conical and/or funnel-shaped and/or stepped segments at the beginning and end of the microwave coupler (6'; 6").

**3.** Probe head according to any one of the previous claims, **characterized in that** the microwave coupler (6; 6'; 6") is designed for a microwave frequency in the range 100 - 1000 GHz, wherein the minimum extent in the rod-shaped region of the microwave coupler (6; 6'; 6") is 0.15 mm/ $\sqrt{\varepsilon_T}$ - 1.5 mm/ $\sqrt{\varepsilon_T}$ and wherein $\varepsilon_T$ is the relative permittivity of the material, from which the microwave coupler (6; 6'; 6") is made.

**4.** Probe head according to any one of the previous claims, **characterized in that** the microwave coupler (6'; 6") has at least one stepped and/or conical and/or funnel-shaped end section (6a, 6b; 6a', 6b'; 6a", 6b").

**5.** Probe head according to any one of the previous claims, **characterized in that** the microwave coupler (6; 6'; 6") has a cross-sectional profile, which is constant in an axially central region, in particular, on its radially outer surface in an axially central region.

**6.** Probe head according to any one of the previous claims, **characterized in that** the microwave waveguide (5) is hollow and has periodic ribbing in the interior.

**7.** Probe head according to any one of the claims 1 to 6, **characterized in that** the axis of the microwave coupler (6; 6'; 6") is disposed transversely, preferably perpendicularly to the axis of rotation of the MAS rotor (3).

**8.** Probe head according to any one of the claims 1 to 6, **characterized in that** the axis of the microwave coupler (6; 6'; 6") is disposed essentially parallel with the axis of rotation of the MAS rotor (3).

**9.** Probe head according to claim 8, **characterized in that** the axial end of the microwave coupler (6; 6'; 6") facing the sample volume is constituted as a base bearing of the MAS stator (2) and is permanently connected thereto.

**10.** Probe head according to any one of the previous claims, **characterized in that** a mirror (7; 7') for reflecting the microwave radiation exiting the microwave coupler (6; 6'; 6") and penetrating through the sample volume (4) is disposed on the side of the MAS stator (2) that is opposite to the microwave coupler (6; 6'; 6").

**11.** Probe head according to any one of the previous claims, **characterized in that** at least one spacer made of dielectric material is provided between the microwave coupler (6; 6'; 6") and the microwave waveguide (5), which bridges a distance of at least one quarter of the wavelength of the microwave radiation to be coupled.

**12.** Probe head according to claim 11, **characterized in**

**that** at least one spacer is constituted as a spacer ring (11), preferably as a multiplicity of spacer rings (11).

13. Probe head according to either one of the claims 11 or 12, **characterized in that** at least one spacer is constituted as a cap (12) that can be plugged onto the microwave waveguide (5), into which the microwave coupler (6; 6'; 6") is integrated.

14. Probe head according to any one of the previous claims, **characterized in that** the microwave coupler (6; 6'; 6") is made of non-magnetic, dielectric materials with a small loss angle ($\tan\delta < 10^{-3}$), in particular, of PTFE or sapphire.

**Revendications**

1. Tête de mesure (10 ; 20) pour la RMN (= résonance magnétique nucléaire)-DNP (= Dynamic Nuclear Polarization ou polarisation nucléaire dynamique)-MAS (= Magic Angle Spinning ou rotation à l'angle magique) avec un stator MAS (2) conçu pour recevoir un rotor MAS (3) contenant une substance échantillon dans un volume d'échantillon (4) et un guide de micro-ondes creux (5) pour amener un rayonnement micro-ondes dans le volume d'échantillon (4) à travers une ouverture (5a) du guide de micro-ondes (5), avec un coupleur de micro-ondes (6 ; 6' ; 6") en forme de barreau constitué d'un matériau diélectrique, étendu le long d'un axe et se trouvant dans l'ouverture (5a) du guide de micro-ondes (5), **caractérisée en ce que** le guide de micro-ondes (5) présente, pour le couplage d'un mode HE11, une section terminale côté échantillon qui définit l'ouverture (5a), dans laquelle le coupleur de micro-ondes (6 ; 6' ; 6") se trouve avec un espacement radial de tous les côtés, ainsi qu'une pièce de transition creuse de forme conique qui s'y raccorde, dans laquelle le coupleur de micro-ondes (6 ; 6'; 6") fait saillie.

2. Tête de mesure selon la revendication 1, **caractérisée en ce qu'**un rayonnement micro-ondes d'une longueur d'onde définie est introduit dans le volume d'échantillon (4) à travers l'ouverture (5a) du guide de micro-ondes (5), et que les dimensions du coupleur de micro-ondes (6 ; 6' ; 6") perpendiculairement à un axe de barreau correspondent au moins à la moitié de la longueur d'onde du rayonnement micro-ondes introduit dans le coupleur de micro-ondes (6 ; 6' ; 6"), sauf dans d'éventuels segments coniques et/ou en forme d'entonnoir et/ou en gradins au début et à la fin du coupleur de micro-ondes (6' ; 6").

3. Tête de mesure selon l'une des revendications précédentes, **caractérisée en ce que** le coupleur de micro-ondes (6 ; 6' ; 6") est dimensionné pour une fréquence de micro-ondes dans la plage de 100 à 1000 GHz, l'étendue minimale dans la zone en forme de barreau du coupleur de micro-ondes (6 ; 6' ; 6") étant de 0,15 mm/$\sqrt{\varepsilon_r}$ à 1,5 mm/$\sqrt{\varepsilon_r}$, $\varepsilon_r$ correspondant à la constante diélectrique relative du matériau dont le coupleur de micro-ondes (6 ; 6' ; 6") est constitué.

4. Tête de mesure selon l'une des revendications précédentes, **caractérisée en ce que** le coupleur de micro-ondes (6' ; 6") présente au moins une section terminale (6a, 6b ; 6a', 6b' ; 6a", 6b") en gradins et/ou de forme conique et/ou en forme d'entonnoir.

5. Tête de mesure selon l'une des revendications précédentes, **caractérisée en ce que** le coupleur de micro-ondes (6 ; 6' ; 6") présente un profil en coupe transversale qui est constant dans une zone centrale axiale, en particulier sur sa surface radialement extérieure dans une zone centrale axiale.

6. Tête de mesure selon l'une des revendications précédentes, **caractérisée en ce que** le guide de micro-ondes (5) est creux et présente une cannelure périodique à l'intérieur.

7. Tête de mesure selon l'une des revendications 1 à 6, **caractérisée en ce que** l'axe du coupleur de micro-ondes (6 ; 6' ; 6") est disposé transversalement, de préférence perpendiculairement à l'axe de rotation du rotor MAS (3).

8. Tête de mesure selon l'une des revendications 1 à 6, **caractérisée en ce que** l'axe du coupleur de micro-ondes (6 ; 6' ; 6") est disposé sensiblement parallèlement à l'axe de rotation du rotor MAS (3).

9. Tête de mesure selon la revendication 8, **caractérisée en ce que** l'extrémité axiale du coupleur de micro-ondes (6 ; 6' ; 6") tournée vers le volume d'échantillon est réalisée sous la forme d'un palier de fond du stator MAS (2) et reliée à celui-ci de manière fixe.

10. Tête de mesure selon l'une des revendications précédentes, **caractérisée en ce que** du côté du stator MAS (2) opposé au coupleur de micro-ondes (6 ; 6' ; 6") est disposé un miroir (7 ; 7') destiné à réfléchir le rayonnement micro-ondes sortant du coupleur de micro-ondes (6 ; 6' ; 6") et traversant le volume d'échantillon (4).

11. Tête de mesure selon l'une des revendications précédentes, **caractérisée en ce qu'**entre le coupleur de micro-ondes (6 ; 6' ; 6") et le guide de micro-ondes (5) est prévu au moins un écarteur en matériau diélectrique qui couvre une distance d'au moins un quart de la longueur d'onde du rayonnement micro-ondes à coupler.

12. Tête de mesure selon la revendication 11, **caractérisée en ce qu'**au moins un écarteur est réalisé sous la forme d'une bague d'écartement (11), de préférence d'une pluralité de bagues d'écartement (11).

13. Tête de mesure selon la revendication 11 ou 12, **caractérisée en ce qu'**au moins un écarteur est réalisé sous la forme d'une coiffe (12) pouvant être montée sur le guide de micro-ondes (5), dans laquelle le coupleur de micro-ondes (6 ; 6' ; 6") est intégré.

14. Tête de mesure selon l'une des revendications précédentes, **caractérisée en ce que** le coupleur de micro-ondes (6 ; 6' ; 6") est constitué de matériaux diélectriques non magnétiques à faible angle de perte (tan $\delta$ < 10$^{-3}$), en particulier en PTFE ou saphir.

10

2          5a          5

7      3      4      5a          6

Fig. 1

Fig. 2

Fig. 3

Fig. 4a

Fig. 4b

Fig. 5a

Fig. 5b

PRIOR ART                    Fig. 6

## Fig. 7

12

## Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102008009376 A1
- DE 102006048955 B4
- DE 102008054152 B3

### In der Beschreibung aufgeführte Nicht-Patentliteratur

- **BARNES, ALEXANDER.** Optimization of THz wave coupling into samples in DNP/NMR spectroscopy. *Proceedings of the 2010 IEEE International Conference on Millimeter and Terahertz Waves,* vol. 1-3
- **MATSUKI.** Dynamic nuclear polarization experiments at 14.1 T for solid-state NMR. *PCCP,* 2010, 5799-5803
- **NANNI.** Microwave Field Distribution in a Magic Angle Spinning Dynamic Nuclear Polarization NMR Probe. *J Magn Reson.,* Mai 2011, vol. 210 (1), 16-23
- **BAJAJ V.** Dynamic nuclear polarization at 9 T using a novel 250 GHz gyrotron microwave source. *J Magn Reson,* 2003, vol. 160 (2), 85-90
- **M. ROSAY.** Solid-state dynamic nuclear polarization at 263 GHz: spectrometer design and experimental results. *PCCP,* 2010, 5850-5860
- **BECERRA.** A Spectrometer for Dynamic Nuclear Polarization and Electron Paramagnetic Resonance at High Frequencies. *J Magn Reson. A,* 1995, vol. 117 (1), 28-40
- **V. DENYSENKOV, TH.PRISNER.** Liquid state Dynamic Nuclear Polarization probe with Fabry Perot resonator at 9.2 T. *J. Magn. Reson.,* 2012, vol. 217, 1-5